## Europäisches Patentamt

## European Patent Office

## Office européen des brevets

(19)

(11) Veröffentlichungsnummer: **0 160 966**
**B1**

(12) **EUROPÄISCHE PATENTSCHRIFT**

(45) Veröffentlichungstag der Patentschrift: **04.04.90**

(21) Anmeldenummer: **85105572.3**

(22) Anmeldetag: **07.05.85**

(51) Int. Cl.⁵: **H 05 K 3/42**, H 05 K 3/18, C 23 C 18/16

(54) **Verfahren zur Herstellung von Metallmustern auf isolierenden Trägern sowie isolierende Träger mit Metallmuster, insbesondere gedruckte Schaltungen.**

(30) Priorität: **11.05.84 DE 3417563**

(43) Veröffentlichungstag der Anmeldung:
**13.11.85 Patentblatt 85/46**

(45) Bekanntmachung des Hinweises auf die
Patenterteilung:
**04.04.90 Patentblatt 90/14**

(84) Benannte Vertragsstaaten:
**AT BE CH DE FR GB IT LI LU NL SE**

(56) Entgegenhaltungen:
**FR-A-2 139 998**
**FR-A-2 147 338**
**GB-A-1 223 939**

(73) Patentinhaber: **Dr.Ing. Max Schlötter GmbH &
Co. KG
Talgraben 30
D-7340 Geislingen/Steige (DE)**

(72) Erfinder: **Roubal, Jiri
Geislinger Strasse 34
D-7347 Bad Überkingen (DE)**

(74) Vertreter: **Lehn, Werner, Dipl.-Ing. et al
Hoffmann, Eitle & Partner Patentanwälte
Arabellastrasse 4
D-8000 München 81 (DE)**

# EP 0 160 966 B1

**Beschreibung**

Die Erfindung betrifft ein Verfahren zur Herstellung von Metallmustern auf isolierenden Trägern, insbesondere von gedruckten Schaltungen, bei denen diese Träger zwecks elektrischer Verbindung mit Löchern versehen sind und die Metallmuster auf der Oberfläche des Trägers mit Hilfe einer Negativmaske nach dem Subtraktivverfahren hergestellt werden.

Bei der Herstellung von durchkontaktierten Leiterplatten nach dem Subtraktivverfahren wird von mit Metallfolien beschichteten Platten aus Isoliermaterial ausgegangen. Als Isoliermaterial werden z.B. glasfaserverstärkes Epoxidharz, Phenolharzpapier, Epoxidharzpapier, Polyimid, PVC und andere verwendet. Die Metallfolien (meist Kupferfolien) sind auf den beiden Aussenflächen angebracht. Aus diesen beidseitig beschichteten Isolierplatten werden zweiseitige Leiterplatten hergestellt. Sind mehrere Lagen von Leiterbildern aufeinandergepresst, wobei eine Trennung durch Isolierstoffe erfolgt, spricht man von mehrlagigen Schaltungen (Multilayerplatten). Die Durchkontaktierung und Herstellung der Metallmuster auf den Aussenflächen von zwei- bzw. mehrlagigen Leiterplatten erfolgt nach dem gleichen Prinzip. Nach der Herstellung der Bohrungen (Durchbrüchen) an den Stellen, wo Verbindungen zu den einzelnen Metallmusterebenen erwünscht sind (z.B. durch Bohren, Stanzen, Fräsen u.ä.) und einem mechanischen Reinigungsprozess der Metallfolie (z.B. Bürsten) erfolgt die Durchkontaktierung und Metallmusterherstellung im Prinzip nach dem folgenden Schema:

I. Durchkontaktierung:
1. Reinigen der Platte in einer wässrigen Reinigungslösung,
2. Anätzen der Metallfolie,
3. Aktivieren,
4. chemisches Metallisieren, vorzugsweise chemisches Verkupfern, und gegebenenfalls
5. galvanisches Verstärken (Verkupfern) der chemisch abgeschiedenen Schicht, wenn bei dem Schritt 4 nur dünne Schichten abgeschieden wurden.

II. Herstellung der Negativmaske mit Hilfe von Siebdruck oder Fotoresist
6. Bürsten der Platten,
7. Beschichten, z.B. mit Fotoresist und Entwickeln des negativen Metallmusters bzw. Beschichten mit Siebdruck.

III. Galvanischer Aufbau der Leiterbahnen:
8. Reinigen,
9. Anätzen,
10. galvanische Kupferabscheidung,
11. Abscheiden von Ätzresist, z.B. Zinn oder Bleizinn.

IV. Ätzen der Leiterplatten:
12. Negativemaske (Fotoresist oder Siebdruck) entfernen,
13. Ätzen des mit Ätzresist unbedeckten Metalls (Kupfers),
14. Aufhellen, Umschmelzen — falls erwünscht.
Es folgt Beschichten mit Lötstopplack, Bestücken und Löten.
Dieses Verfahren wird in der Fachsprache als "Metallresistverfahren" bezeichnet.

Die angeführten Verfahrensfolgen stellen das Prinzip des Verfahrens dar. Jeder Fachmann erkennt, an welchen Stellen des Verfahrensablaufs, z.B. Spülprozesse stattfinden müssen, oder an welcher Stelle die Platten auf geeignete Vorrichtungen (z.B. Gestelle, Körbe) befestigt bzw. aufgelegt werden, um diese während der Herstellung zu transportieren. Nach einigen Verfahrensschritten wird der Prozess unterbrochen; die Platten können über einen bestimmten Zeitraum gelagert werden.

Der Schritt Aktivierung stellt einen Vorgang dar, bei dem Metallkeime an der Wandung der Löcher niedergeschlagen werden, um die nachfolgende chemische Metallabscheidung an der Lochwandung in Gang zu bringen. Die Aktivierung erfolgt in mehreren Verfahrensschritten, wie z.B.:
Vortauchen,
eigentliche Aktivierung in einer Lösung, die Kolloide auf der Basis Zinn-Palladium enthält,
Spülen,
Konditionieren (Beschleunigen), z.B. in einer HBF$_4$-Lösung.
Bei einem anderen Aktivierungsverfahren werden Kolloide auf der Basis von Kupfer verwendet. Diese Aktivierungsverfahren ist in EPA 0 044 878 beschrieben.
Aktivierung auf Basis von Metallkolloid haben bestimmte Nachteile, wie nachfolgend erläutert wird. Als Alternative können ionogene Edelmetallösungen, z.B. entsprechend DE—OS 2 116 389, verwendet werden.
Eine andere Möglichkeit bei der Herstellung von durchkontaktierten Leiterplatten nach dem Subtraktivverfahren stellt die sogenannte Tenting-Technik dar. Nach diesem Verfahren ist der Verfahrensablauf im Vergleich zu der bereits beschriebenen Metallresisttechnik in den Verfahrensschritten 1—5 im Prinzip gleich. Durch die Wahl der Arbeitsbedingungen wird bei den Verfahrensschritten 4 bzw. 5 die

2

Endschichtdicke an Kupfer erreicht. Dann folgen:

II.a Herstellung von Positivmaske mit Hilfe von Fotoresist
     6.a Reinigen der Oberfläche durch Bürsten,
     7.a Beschichten mit Fotoresist, Entwicklung, wobei der Fotoresist ein Positivbild bildet.

III.a Ätzen, Heissverzinnen
     8.a Ätzen, Entfernen der Positivmaske (Fotoresist),
     9.a Lötstopplack,
     10.a Heissverzinnen.

Vollständigkeitshalber sollen noch die additiven und semiadditiven Verfahren zur Herstellung von Leiterplatten erwähnt werden. Als Grundmaterial werden unkaschierte Platten aus glasfaserverstärktem Epoxidharz, Epoxidharzpapier oder Phenolharzpapier, die mit Haftvermittler beschichtet sind, verwendet.

Die erwähnten Verfahren gehören zum Stand der Technik und werden z.B. im Handbuch der Leiterplattentechnik, Eugen Leuze Verlag, 1982, beschrieben.

Das Metallresistverfahren ist im Vergleich zu anderen Verfahren (Tenting-Technik, Additiv-, Semiadditivverfahren) das meist verbreitete Verfahren für die Herstellung von durchkontaktierten Leiterplatten. Dieses Verfahren ist vom Standpunkt der technischen Praxis zuverlässig, ausgereift und wirtschaftlich.

Trotzdem weist dieses Verfahren in der Form, wie es zur Zeit angewendet wird, eine Reihe von Nachteilen auf:

Die Anzahl der Verfahrensschritte ist relativ gross. Die Aktivierung, besonders die chemische Metallisierung und die galvanische Verstärkung in dem Abschnitt I (Durchkontaktierung) erfolgen auf der gesamten Fläche der Metallfolie.

An den Stellen, wo keine Leiterbahnen vorgesehen sind, ist die Metallabscheidung an sich zwecklos, und bedeutet nur einen Mehraufwand bei der Abscheidung, dem Ätzen und der Entsorgung.

Die Aktivierungssysteme auf der Basis von Kolloidlösungen sind trotz gewisser Verbesserungen, die in den letzten Jahren erreicht wurden, im Vergleich zu ionogenen, "echten" Lösungen nicht sehr stabil, empfindlich gegen Verunreinigungen und aufgrund des relativ komplizierten Herstellungsverfahrens sehr teuer.

Bei dem Schritt 4 (chemische Metallisierung) werden fast ausahmslos chemische Kupferbäder verwendet. Bezüglich des Aufwandes bei der Badführung und -pflege wäre eine chemische Nickelabscheidung im Vergleich zur Kupferabscheidung günstiger. Der Aufwand bei der Abwasserbehandlung von Konzentraten und Spülwässern, die chemische Metallisierungsbäder enthalten, ist besonders bei schwach sauren Nickelbädern nicht so hoch wie bei in der Praxis verwendetn alkalischen Kupferbädern, die starke Komplexbildner, wie z.B. EDTA, enthalten.

Die Anwendung von chemischen Nickelbädern hätte jedoch einen schwerwiegenden Nachteil:

Bei dem Metallresistverfahren müssen Ätzlösungen verwendet werden, die das Kupfer mit einer ausreichenden Geschwindigkeit ätzen, jedoch den Metallresist (z.B. Zinn oder Bleizinn) nicht angreifen. Geeignet für diesen Zweck sind schwach alkalische Ätzlösungen. Nickel wird in diesen Ätzlösungen sehr langsam oder gar nicht angegriffen. Die Ätzung (Verfahrensabschnitt IV, Schritt 13) wäre stark gestört oder sogar undurchführbar. Dies bedeutet, dass die Herstellung des Leiterbildes gar nicht möglich wäre.

Die Verfahrensabschnitte I und III der Metallresisttechnik sind eine Folge von verschiedenen Behandlungen in wässrigen Lösungen. Die Leiterplatten werden in einer Aufnahmevorrichtung (z.B. Gestell) befestigt und entsprechend dem Verfahrensablauf behandelt. Der Transport zwischen den Behandlungsbädern erfolgt zügig, manuell oder mit Hilfe einer automatischen Anlage.

Eine Unterbrechung des zügigen Ablaufs stellt der Verfahrensabschnitt II dar. Die Platten müssen von der Aufnahmevorrichtung (Gestell) abgenommen werden. Obwohl eine mechanische Bearbeitung der Platte (Bürsten) bereits vor der Durchkontaktierung erfolgte, muss dieser Verfahrensschritt wegen der nachfolgenden Aufbringung von Fotoresist oder Siebdruck nochmals wiederholt werden. Nach der Herstellung der Negativmaske werden die Platten erneut z.B. auf Gestellen befestigt; anschliessend erfolgt die weitere Behandlung. Die Reinigung und die Anätzung muss ebenfalls wiederholt werden. Die Anätzung an dieser Stelle ist besonders kritisch, da der noch dünne Überzug auf der Oberfläche der Lochwandlung sehr leicht durchgeätzt werden kann. Durchätzungen dieser Art, auch wenn sie nur stellenweise erfolgen und dadurch unbemerkt bleiben, verursachen Fehler beim Lötprozess (sog. "Ausgasungen").

Um die Unterbrechung zwischen den Verfahrensabschnitten I und III auszuschliessen, müsste die Negativmaske bereits vor der Durchkontaktierung auf die Leiterplatten aufgebracht werden. Diese Verfahrensvariante würde jedoch unüberwindbare Schwierigkeiten mit sich bringen. Erfolgt das Aufbringen der Negativmaske vor der Aktivierung, dann wird — bei der Verwendung von üblichen Aktivatoren — nicht nur die Lochwandung sondern gleichzeitig auch die Negativmaske aktiviert. Auf den aktivierten Flächen wird sich ein Metallniederschlag im chemischen Metallisierungsbad abscheiden. Die daraus zwangsläufig resultierende Bedeckung der Negativmaske mit Metall macht die Herstellung des Leiterbildes unmöglich.

Aufgabe der vorliegenden Erfindung ist es, ein Metallresistverfahren zur Verfügung zu stellen, das die vorhandenen Nachteile der bekannten Methoden vollständig oder mindestens weitgehend eliminiert.

# EP 0 160 966 B1

Das erfindungsgemässe Verfahren der eingangs beschriebenen Art ist durch den nachfolgenden Verfahrensablauf gekennzeichnet:

1. Behandlung in gasförmigem Schwefeltrioxid,

2. Aufbringen einer dem herzustellenden Metallmuster entsprechenden Negativmaske,

3. Durchkontaktierung und anschliessender Aufbau des Metallmusters, realisiert durch die folgenden Verfahrensschritte: Aktivierung mittels einer ionogenen Edelmetallösung, Behandlung in einer Reduktionsmittellösung, chemische oder chemische und galvanische Abscheidung, wobei die Aktivierung und die Metallabscheidung nur auf der Oberfläche der herzustellenden Metallmuster stattfindet.

Das Verfahren hat gegenüber dem bisher bekannten Verfahren folgende Vorteile:

Die Abscheidung erfolgt nur an Stellen, wo es erwünscht und zweckmässig ist. Dadurch werden Einsparungen bei der Metallabscheidung, dem Ätzen und der Abwasserbehandlung erzielt. Die Durchkontaktierung muss nicht nur ausschliesslich durch chemische Verkupferung verwirklicht werden. Eine chemische Vernickelung ist für diesen Zweck ebenso brauchbar. Das Verfahren kommt im Vergleich zu herkömmliche Verfahren mit weniger Verfahrensschritten aus. Die mechanische Bearbeitung der Platten (Bürsten) wird nur einmal durchgeführt. Eine Reinigung und Anätzung der Oberfläche des gewünschten Metallmusters vor der chemischen bzw. galvanischen Verstärkung des Leiterbildes kann entfallen. Die Gefahr der Durchätzung des Metallniederschlages an der Lochwandung wird ausgeschlossen.

Einzelne Verfahrensschritte sind z.B. beim Metallisieren von Kunststoffen etc. als solche bekannt. Überraschend sind jedoch die Vorteile, die sich durch Kombination bekannter Verfahrensschritte in der angegebenen Reihenfolge ergeben.

Die Behandlung in gasförmigem Schwefeltrioxid gehört zu den bekannten Mitteln für die Konditionierung von Nichtleitern zwecks einer nachfolgenden Metallisierung. Dieses Verfahren ist in der DE—PS 2 126 781 beschrieben.

Chromsäure bzw. Chromsäure/Schwefelsäure-Lösungen stellen ebenfalls bekannte Konditionierungsmittel für Kunststoffe dar. Der Behandlung in chromsäurehaltigen Lösungen wird in einigen Fällen noch ein Behandlungsschritt vorgeschaltet, bei dem die Kunststoffoberfläche in einem bestimmten Masse aufgerauht bzw. angequollen wird. Diese Behandlung ermöglicht eine brauchbare Reaktion des Kunststoffes in den chromsäurehaltigen Lösungen bezüglich der vollständigen Bedeckung mit Metall bei der chemischen Metallabscheidung und der Haftfestigkeit des Metallniederschlages auf der Kunststoffoberfläche.

Ein Verfahren, das sich besonders auf die Herstellung von Leiterplatten bezieht, wird in der DE—OS 2 105 845 beschrieben. Nach diesem Verfahren werden Epoxidharzlaminate zuerst in einer wässrigen Lösung von Dimethylformamid, anschliessend in einem Chromsäure/Schwefelsäure-Wasser-Gemisch behandelt. Die auf diese Art und Weise konditionierten Platten werden in einer Lösung, die Kolloide auf Basis Zinn-Palladium enthält, aktiviert. Das Leiterbild wird additiv oder semiadditiv hergestellt.

Die Konditionierungsmittel auf Chromsäurebasis, mit oder ohne Anquellen, sind für das Verfahren gemäss der Erfindung nicht geeignet. Bei der Anwendung von für das Verfahren brauchbaren Aktivierungen, deren Zusammensetzung und Arbeitsbedingungen noch näher erläutert werden, wird keine vollständige Metallisierung der Lochwandungen in dem chemischen Metallisierungsbad erzielt.

Wie in der DE—PS 2 126 781 beschrieben, stellt das Verfahren bei dem die Kunststoffoberfläche mit gasförmigem Schwefeltrioxid behandelt wird, eine vorteilhafte Alternative zu Verfahren, bei denen die Kunststoffoberfläche mit Hilfe von chromsäurehaltigen Lösungen konditioniert wird, dar.

Beide Verfahren setzen sich — wie andere Verfahren zur Metallisierung von Kunststoffen — aus folgenden Verfahrensschritten zusammen.

1. Konditionieren,

2. Aktivierung mit Edelmetallsalz, oder

2a Sensibilisieren in Lösungen, die Salze von Zinn(II) enthalten, anschliessend Aktivieren in Edelmetallsalzlösungen,

3. Behandlung in einer Reduktionsmittellösung,

4. Chemische Metallisierung.

Aus der DE—PS 2 126 781 geht keineswegs hervor, dass die Konditionierung im gasförmigen Schwefeltrioxid für die Herstellung von Metallmustern auf isolierenden Trägern nach Subtraktivverfahren geeignet ist. Die Beispiele 19 bis 22 der Patentschrift beschreiben Möglichkeiten für die Herstellung von Leiterplatten nach dem Semiadditiv- bzw. Additivverfahren. Der Verfahrensablauf gemäss der Erfindung ist in dieser Patentschrift weder erwähnt noch irgendwie angedeutet.

Der Verfahrensablauf gemäss der Erfindung weist gegenüber dem Verfahren nach DE—PS 2 126 781 grundsätzliche Unterschiede auf. Bei dem Verfahren nach DE—PS 2 126 781 werden die Kunststoffe unmittelbar nach der Behandlung im gasförmigen Schwefeltrioxid aktiviert. Die zum Aktivieren verwendete Palladiumlösungen sind für das Verfahren nach der Erfindung zwar brauchbar, jedoch nicht vorteilhaft, wie es noch später erläutert wird. Die Aktivierung auf der Basis von Behandlung in Zinn- und anschliessend in Palladiumlösungen ist unbrauchbar, da nicht nur die Lochwandung der Isolierplatten sondern auch die Negativmaske aktiviert und dadurch nachfolgend metallisiert werden. Als besonders überraschend hat es sich herausgestellt, dass Unterbrechungen und Zwischenbehandlugen vor der Aktivierung nach der vorliegenden Erfindung möglich sind. Es ist für den Fachmann nicht selbstverständlich, dass die nach der Konditionierung empfindlich reagierende Kunststoffoberfläche ohne

4

weiteres mehrmals getrocknet und der Wirkung von verschiedenen Lösungen, wie Entwicklungslösung für Fotoresist, netzmittelhaltigen Reinigungslösungen und den oxidierenden Lösungen zum Anätzen der Metallfolie vor dem Verfahrensschritt der Aktivierung ausgesetzt werden kann, ohne dabei die Fähigkeit der brauchbaren Aufnahme des Edelmetalls zu verlieren. Dem Fachmann wäre es eher verständlich, die Unterbrechung des Prozesses und das Aufbringen der Negativmaske erst nachdem die Edelmetallkeime auf der Oberfläche fixiert sind, d.h. nach dem Verfahrensschritt des Aktivierens und der Behandlung in einer Reduktionsmittellösung, unmittelbar vor der chemischen Metallisierung, vorzunehmen. Es hat sich jedoch gezeigt, dass diese Verfahrensvariante zu keiner vollständigen Bedeckung der Lochwandung mit Metall, d.h. zu keiner einwandfreien Durchkontaktierung führt.

Die Massnahmen für die Anwendung des gasförmigen Schwefeltrioxids für die Vorbehandlung von Kunststoffen sind aus der DE—PS 2 126 781 bekannt und gelten im Prinzip auch für das Verfahren gemäss der vorliegenden Erfindung. Die Haftung des Metallniederschlages an der Lochwandung wird durch die Aufrauhung der Lochwandung bei der Herstellung der Löcher (Bohren) begünstigt. Wegen diesen bereits gegebenen, für die Haftung günstigen Strukturen der Oberfläche stehen bei der Wahl der Behandlungsbedingungen — im Vergleich zu Fällen, wo Kunststoffe mit glatten Oberflächen zu metallisieren sind — noch grössere Toleranzbereiche zur Verfügung. Für die meisten Kunststoffe wurden Konzentrationen aus dem Bereich von 10 mg/l $SO_3$ bis zu $SO_3$-Konzentration, die dem Dampfdruck über 65%igem Oleum bei 25°C entspricht, angewendet. Die Behandlungsdauer wird im Bereich von 1 Sekunde bis 20 Minuten, vorzugsweise von 10 Sekunden bis 5 Minuten, gewählt.

Das Aufbringen der Negativmaske mit Hilfe von z.B. Siebdruck, Fotolack oder Fotoresistfolie ist, getrennt betrachtet, ein bekanntes Verfahren und braucht nicht weiter erläutert zu werden.

Nach der Herstellung der Negativmaske, i.e. vor der Aktivierung, werden die Platten in wässrigen Lösungen gereinigt. Die Reinigung kann für diesen Zweck in handelsüblichen Reinigungsmitteln vorgenommen werden. Diese Reinigungsmittel reagieren je nach Typ entweder sauer oder alkalisch und enthalten Säuren, wie Phosphorsäure, Schwefelsäure, im anderen Fall Alkali, weiterhin anorganische Neutralsalze, verschiedene organische Verbindungen, besonders Netzmittel. Es ist verständlich, dass bei der Anwendung von alkalilöslichen Fotoresisten nur die sauer reagierenden Reinigungsmittel anwendbar sind. Einige Reinigungsmittel enthalten Substanzen, die die chemische Metallisierung im starken Masse behindern können, sogenannte Katalysatorgifte. Zur Gruppe dieser Substanzen gehört z.B. Thioharnstoff. Verständlicherweise soll die Anwendung von solchen Substanzen in diesen Reinigungsmitteln möglichst vermieden werden um die nachfolgende chemische Metallisierung nicht zu stören.

Für die Anätzung der Metallfolie (in den meisten Fällen der Kupferfolie) werden übliche Ätzungsmittel auf der Basis von Persulfaten oder Wasserstoffperoxid verwendet.

Für das Verfahren gemäss der Erfindung sind grundsätzlich Lösungen von Edelmetallsalzen anwendbar; die Behandlung in einer Reduktionsmittellösung schliesst sich an; Aktivierungssysteme, die mit Metallkolloiden arbeiten, oder System, bei denen die Platten zuerst in Zinn(II)-Salzen sensibilisiert und dann in Lösungen von Edelmetallsalzen aktiviert werden, sind wegen ihrer gleichzeitigen Wirkung auf die Oberfläche der Lochwandung und auf die Negativmaske unbrauchbar.

Lösungen von Edelmetallsalzen neigen zur Hydrolyse. Um die Hydrolyse zu verhindern, wird der pH-Wert durch Zugabe von Säuren auf niedrigere Werte eingestellt. Aus Edelmetallösungen, besonders aus sauren Lösungen, in denen das Edelmetallion unkomplexiert vorliegt, wird das Edelmetall auf Oberflächen von unedlen Metallen durch Ionenaustausch abgeschieden. Die ionogenen Edelmetallösungen, die für die Aktivierung der Nichtleiter für die nachfolgende Galvanisierung verwendet werden, wie z.B. in DE—PS 2 126 781 beschrieben, weisen diesen Nachteil auf. Bei der üblichen Metallisierung von Nichtleitern spielt dieser Nachteil keine Rolle, da nur Nichtleiteroberflächen behandelt werden. Bei dem Subtraktivverfahren werden gleichzeitig Nichtleiter und Metall (Kupferfolie) behandelt. Die Abscheidung durch Ionenaustausch findet statt.

Massnahmen, die zur Verhinderung der Zementierung auf unedleren Metallen führen, sind bekannt. Bei der galvanischen Abscheidung von Palladium wird dies z.B. durch Anheben des pH-Wertes und Zugabe von Komplexbildnern, wie z.B. Ammoniumsalzen, verhindert. Diese Lehre ist z.B. aus Metall Finishing Guidebook, S. 357—359, Metals and Plastics Publications Inc. 381 Broadway, Westwood, New Jersey, USA (1962) oder aus dem Handbuch der Galvanotechnik, Band II, S. 428, Carl Hanser Verlag, München, 1966, zu entnehmen.

Ausser galvanischen und chemischen Palladiumbädern sind Anwendungen von stickstoffhaltigen Verbindungen in Aktivierungslösungen aus DE—PS 1 621 207 und DE—OS 2 116 389 bekannt. Nach DE—PS 1 621 207 wird ein Verfahren beansprucht, in dem die Kunststoffoberflächen zuerst in Zinn(II)-Salzlösungen sensibilisiert und anschliessend in Palladium-Salzlösungen, die zusätzlich eine stickstoffhaltige Verbindung enthalten, aktiviert. Der pH-Wert dieser Lösung wird so eingestellt, dass kein Palladium auf dem Kupfer zementativ abgeschieden wird, jedoch noch eine Reaktion zwischen Zinn(II)-Verbindungen und dem Palladium auf der Oberfläche stattfindet. DE—PS 1 621 207 nutzt die zum Zeitpunkt der Anmeldung dieser Erfindung bereits bekannte Tatsache, dass die Palladiumzementierung durch Zugabe von stickstoffhaltigen Verbindungen verhindert wird. Durch Zugabe von stickstoffhaltigen Verbindungen wird die Aktivität des Palladiumions in bezug auf die Aktivierung vermindert. Gemäss DE—PS 1 621 207 wurden Arbeitsbereiche gefunden, in denen die Aktivierung mit Palladiumsalzlösungen, die stickstoffhaltige Verbindungen enthalten, im Anschluss an die Sensibilisierung möglich ist. In dieser

EP 0 160 966 B1

Druckschrift wird als Ausführungsbeispiel das bekannte Durchkontaktierungsverfahren mit diesem modifizierten Aktivatorsystem angeführt. Diese Aktivierungssysteme sind für das Verfahren nach der vorliegenden Erfindung wegen der möglichen Metallisierung der negativen Maske, wie bereits beschrieben, unbrauchbar.

Bei dem Verfahren nach DE—OS 2 116 389 wird die Kunststoffoberfläche in einer Lösung von Edelmetallsalzen, die zusätzlich eine stickstoffhaltige Verbindung enthält, aktiviert, in einer Lösung von z.B. Dimethylaminoboran oder Natriumhypophosphit zwecks Reduktion des Edelmetalls behandelt und anschliessend in einem chemischen Kupferbad metallisiert. In der Beschreibung von DE—OS 2 116 389 wird besonders darauf hingewiesen, dass diese Aktivierung für die Herstellung der durchkontaktierten Leiterplatten nach dem bekannten Verfahren, wobei die gesamte Oberfläche der Kupferfolie aktiviert und chemisch metallisiert wird, geeignet sind.

Die Funktionsfähigkeit der Aktivierungslösung nach DE—OS 2 116 389 ist vom pH-Wert stark abhängig. Weiterhin gibt es Unterschiede zwischen den einzelnen stickstoffhaltigen Verbindungen in bezug auf die Aktivierung. Die Verwendung von 2-Aminopyridin ist z.B. günstiger als die Verwendung von Ammoniak bzw. Ammoniumsalz.

Gemäss den Beispielen von DE—OS 2 116 389 wird dem Edelmetallsalz eine stickstoffhaltige Verbindung zugesetzt, der pH-Wert wird dann auf ca. 7 angehoben. Diese Lösungen sind für das Verfahren gemäss der Erfindung ebenfalls unbrauchbar, da sich Metall nach der Einwirkung von solchen Aktivierungslösungen im chemischen Metallisierungsbad nicht nur an der Lochwandung, sondern auch auf der Oberfläche der Negativmaske abscheidet, wie im Beispiel Nr. 14 gezeigt wird.

Die für die vorliegende Erfindung brauchbare bzw. vorzugsweise anwendbaren Aktivierungslösungen sollen nach Möglichkeit folgende Forderungen gleichzeitig erfüllen:

1. Eine ausreichende Belegung mit Edelmetall, bezüglich der vollständigen Metallisierung der Lochwandung (Nichtmetall) muss gewährleistet sein.

2. Die Zementierung des Edelmetalls auf der Metallfolie (Kupfer) soll überhaupt nicht oder nur in geringem Masse stattfinden.

3. Die Negativmaske darf nicht aktiviert werden.

In der zitierten Patentliteratur werden Verfahren beschrieben, bei denen eine ausreichende Aktivierung von Nichtleitern (Kunststoffen) bei einer gleichzeitigen Verhinderung der Edelmetallzementierung auf unedleren Metallen (z.B. Kupfer) stattfindet. Die bezüglich der Nichtleiter gegebene Wirkung ist jedoch bei der vorliegenden Erfindung unerwünscht, da sonst die Negativmaske (Nichtleiter) metallisiert wird.

Es wurde gefunden, dass Edelmetallösungen, die Verbindungen des basischen Stickstoffs enthalten, bei bestimmten Arbeitsbedingungen (Konzentrationen, pH-Wert) alle obengenannten Bedingungen erfüllen können. Es hat sich gezeigt, dass bei der Behandlung in den Aktivierungslösungen gemäss der Erfindung die Edelmetallzementierung sehr stark begrenzt wird und gleichzeitig die Wirkung der Aktivierung auf die in gasförmigem Schwefeltrioxid behandelte Kunststoffoberfläche ungestört bleibt. Aus der genannten Patentliteratur konnte nicht abgeleitet werden, dass eine völlig andere, zum Teil gegensätzliche Wirkung mit Lösungen, die stickstoffhaltige Substanzen enthalten, erzielt werden kann.

Die Aktivierungslösungen gemäss der Erfindung enthalten Edelmetallsalz, vorzugsweise Palladiumsalz, in Konzentrationen, die 50 mg/l bis 1 g/l, vorzugsweise 100 mg/l bis 200 mg/l Palladium, entsprechen. Als Salze können beliebige wasserlösliche Salze, wie z.B. Chloride, Nitrate, Sulfate, verwendet werden. Als stickstoffhaltige Verbindungen werden Ammoniak, primäre, sekundäre, tertiäre Amine und andere Verbindungen, die basischen Stickstoff enthalten, sowie Salze dieser Verbindungen, verwendet. Als Beispiele seien genannt: Ethylamin, Butylamin, Ethylendiamin, Pyridin, Harnstoff, Ethylhexylamin, Taurin, Glycin. Diese Verbindungen können z.B. als Sulfate, Chloride, Nitrate verwendet werden.

Die anwendbare Konzentration der stickstoffhaltigen Verbindungen ist von der Palladiumkonzentration abhängig. Das Verhältnis der molaren Konzentration, bezogen auf die Aminogruppen, zur molaren Konzentration des Palladiumions soll mindestens 2 betragen. Der pH-Wert der Lösung wird zwischen 1 bis 7, vorzugsweise 2 bis 3, eingestellt.

Dem Fachmann ist es verständlich, dass die Art der stickstoffhaltigen Verbindung, die Konzentrationen des Palladiums und der stickstoffhaltigen Verbindung sowie der pH-Wert die Brauchbarkeit der Aktivierung beim Verfahren nach der vorliegenden Erfindung beinflussen werden.

Ammoniak bzw. Ammoniumsalze sind für das Palladiumion schwächere Komplexbildner als z.B. Ethylendiamin. Zwecks Verbindung der Palladiumabscheidung auf Kupfer werden kleinere Konzentrationen an Ethylendiamin benötigt als bei der Verwendung von Ammoniak. Andererseits sind die Aktivierungen bezüglich der vollständigen Bedeckung der Lochwandung im chemischen Metallisierungsbad gegenüber höheren Konzentrationen an Ammoniak nicht sehr empfindlich. Überdosierungen der starken Komplexbildner (Ethylendiamin) können die Wirkung des Palladiums unter ein brauchbares Mass vermindern und dadurch die vollständige Bedeckung des Nichtleiters verhindern.

Die Arbeitsbedingungen (Konzentrationen, pH-Wert) beeinflussen die Brauchbarkeit der Aktivierungslösung gegenseitig. Der günstigste Arbeitsbereich der Aktivierung lässt sich leicht durch einige wenige Versuche ermitteln:

Nach dem Auflösen des Palladium-Salzes wird die stickstoffhaltige Verbindung zugesetzt und der pH-Wert auf z.B. 2 bis 3 eingestellt. Anschliessend werden, wie nachfolgend beschrieben, Prüfungen

6

durchgeführt, wobei gegebenenfalls die Bedingungen in Richtung des gewünschten Ergebnisses variiert werden:

1. Prüfung der Palladiumzementierung auf der Metallfolie (Kupfer). Die Zementierung wird durch eine Erhöhung und/oder durch eine Erhöhung der Konzentration der stickstoffhaltigen Verbindung vermindert.

2. Prüfung der Deckung der Lochwandung im chemischen Metallisierungsbad, wobei die gebohrten Platten im gasförmigem Schwefeltrioxid konditioniert und anschliessend gereinigt, angeätzt und in der vorliegenden Aktivierungslösung aktiviert werden.

Eine niedrigere Konzentration der stickstoffhaltigen Verbindung und/oder eine höhere Palladiumkonzentration begünstigen des Ergebnis bei der chemischen Metallisierung.

3. Prüfung der Bedeckung der Negativmaske. Die Probe wird wie unter 2. beschrieben behandelt, die Konditionierung wird jedoch nicht angewendet. Im Prinzip entspricht diese Prüfung dem Verfahren gemäss DE—OS 2 116 389 bzw. DE—PS 1 621 207. In bezug auf diese Druckschriften ist an dieser Stelle ein *negatives* Ergebnis anzustreben:

Die Bedeckung des Nichtleiters (Negativmaske) darf nicht stattfinden. Dies ist gegebenenfalls bereits durch Absinken des pH-Wertes in den meisten Fällen erreichbar.

Die Prüfungen können getrennt (drei getrennte Proben) oder an einer gebohrten, in Schwefeltrioxid konditionierten und anschliessend mit einer Negativmaske beschichteten Probe gleichzeitig durchgeführt werden. Die Beispiel 6 und 7 demonstrieren das Vorgehen bei den Prüfungen.

Die Temperatur, die bei der Aktivierungslösung angewendet wird, ist nicht kritisch. Verständlicherweise wird die Aktivierung bei Raumtemperatur angewendet, höhere sowie niedrigere Temperaturen sind zulässig. Eine Einwirkungsdauer von 20 Sekunden bis 10 Minuten, vorzugsweise von 1 bis 3 Minuten, ist ausreichend.

Nach der Aktivierung folgt eine Behandlung in einer Reduktionsmittellösung, z.B. in Lösung von Dimethylaminoboran. Der pH-Wert dieser Lösung wird vorzugsweise schwach sauer eingestellt (z.B. pH = 5), um den Angriff der alkalilöslichen Resiste auszuschliessen.

Die chemische Metallisierung kann in einem chemischen Kupferbad oder einem chemischen Nickelbad erfolgen. Alkalische chemische Kupferbäder sind bei der Verwendung von alkalilöslichen Resisten nicht geeignet. Um eine universelle Anwendung des Verfahrens zu ermöglichen, sind vorzugsweise schwach saure chemische Nickelbäder anzuwenden.

Handelsübliche und in der Praxis angewendete chemische Nickelbäder enthalten Nickelsalze, Komplexbildner (meist organische Säuren und deren Salze), Reduktionsmittel (meist Natriumhypophosphit oder Aminoborane), und Stabilisatoren (z.B. Verbindungen von zweiwertigem Schwefel oder Schwermetalle). Diese Bäder können ohne prinzipielle Einschränkung verwendet werden. Vorzugsweise werden Bäder verwendet, die Aminoboranverbindungen allein oder neben Natriumhypophosphit als Reduktionsmittel enthalten. Diese Bäder können dann bei relativ niedrigen Temperaturen (bis 50°C) arbeiten. Dadurch wird eine mögliche Temperaturbelastung der Negativmaske niedrig gehalten und eine gegebenenfalls daraus resultierende zu starke Dehnung der Negativmaske, verbunden mit Blasenbildung, Abblätterung u.ä., wird weitgehend vermieden.

Der weitere Aufbau des Leiterbildes wird nach konventionellen Methoden durchgeführt. Meistens folgt an dieser Stelle eine galvanische Kupferabscheidung in sauren Bädern sowie Abscheiden von Metallätzresist (z.B. Zinn, Bleizinn, Nickel, Gold u.ä.). Eine chemische Abscheidung, z.B. in einem chemischen Kupferbad, ist im Prinzip möglich, wenn geeignete (alkalibeständige) Negativmasken verwendet werden.

Die nachfolgenden Beispiele zeigen mögliche Anwendungen des Verfahrens, ohne dass dadurch die Erfindung eingeschränkt werden soll.

Die Vergleichsbeispiele beziehen sich auf die oben angeführten Erläuterungen.

Beispiel 1

Aus einer kupferkaschierten Epoxidharzplatte wurde eine gedruckte Schaltung hergestellt. Behandlungsfolge:

1. Bohren der Platte;
2. Behandlung in einer SO₃-haltigen Atmosphäre, die im Gleichgewicht mit Oleum, das 35% Schwefeltrioxid enthielt, bei Raumtemperatur 20 Sekunden lang;
3. Spülen mit Wasser;
4. Trocknen der Platte;
5. Bürsten der Platte, Beschichten mit einer handelsüblichen alkalilöslichen Fotoresistfolie, Herstellung einer Negativmaske;
6. Befestigen der Platte auf einem Gestell;
7. Reinigen in einem handelsüblichen sauren Reiniger, 5 Minuten bei Raumtemperatur;
8. Spülen in Wasser;
9. Ätzen in einer Natriumpersulfatlösung, 2 Minuten bei Raumtemperatur;
10. Spülen mit Wasser;
11. Aktivieren in einer Lösung folgender Zusammensetzung:

Palladium (als Palladiumnitrat): 200 mg/l
Schwefelsäure; konzentriert:      20 g/l

Ammoniaklösung, konzentriert    25 g/l

pH auf 2,6 eingestellt. Die Behandlung erfolgte bei Raumtemperatur 2 Minuten lang.

12. Spülen in Wasser;

13. Behandlung in einer Dimethylaminoboranlösung (1 g/l), pH 5,5, 1 Minute bei Raumtemperatur;

14. Spülen in Wasser;

15. Chemische Vernickelung bei 45°C, 15 Minuten. Das chemische Nickelbad hatte folgende Zusammensetzung:

| | |
|---|---|
| Nickel als Nickelsulfat: | 7 g/l |
| Milchsäure: | 30 g/l |
| Natriumhypophosphit: | 10 g/l |
| Dimethylaminoboran: | 2 g/l |
| Blei (als Acetat): | 0,3 mg/l |
| pH des Bades (eingestellt mit Natriumhydroxid): | 5,5 |

16. Spülen in Wasser;

17. Tauchen in eine 5%ige Schwefelsäure 20 Sekunden bei Raumtemperatur;

18. galvanisches Verkupfern im handelsüblichen Schwefelsauren Kupferbad; Schichtdicke 25 µm;

19. Spülen in Wasser;

20. Tauchen in Säure;

21. Abscheiden von Bleizinnüberzug aus handelsüblichem Bleizinnbad;

22. Spülen in Wasser und Trocknen der Platte;

23. Abnehmen der Platte vom Gestell;

24. Entfernen der Fotoresistfolie, Ätzen der freibleibenden Kupferfolie.

Die Leiterplatte wurde optisch geprüft unter dem Binokularmikroskop. Es wurden keine Fehler (Durchkontaktierung, Konturen der Leiterbahnen) festgestellt.

Beispiel 2

Vier kupferkaschierte, gebohrte Platten aus glasfaserverstärktem Epoxidharz wurden analog zu Beispiel 1 behandelt. Die Bedingungen bei der Behandung in der schwefeltrioxidhaltigen Atmosphäre waren:

| | | |
|---|---|---|
| 1. | SO$_3$-Konzentration im Oleum: | 35% |
| | Behandlungsdauer: | 20 Sek. |
| 2. | SO$_3$-Konzentration im Oleum: | 35% |
| | Behandlungsdauer: | 40 Sek. |
| 3. | SO$_3$-Konzentration im Oleum: | 42% |
| | Behandlungsdauer: | 20 Sek. |
| 4. | SO$_3$-Konzentration im Oleum: | 50% |
| | Behandlungsdauer: | 20 Sek. |

Bei der galvanischen Kupferabscheidung (Schritt Nr. 18) wurde ein 5 µm dicker Überzug abgeschieden.

Bei einer optischen Prüfung der Leiterplatten wurde eine einwandfreie Durchkontaktierung und ein einwandfreier Aufbau des Leiterbildes festgestellt.

Beispiel 3

Analog des Beispiels 2 wurden eine kupferkaschierte PVC-Folie und eine Platte aus kupferkaschiertem Epoxidharzpapier behandelt. Die Herstellung der Löcher erfolgte durch Stanzen, die Negativmaske wurde durch Siebdruckfarbe hergestellt. Die Bedingungen bei der Behandlung im gasförmigen Schwefeltrioxid waren:

| | | |
|---|---|---|
| Für PVC: | | |
| | Oleumkonzentration | 65% SO$_3$ |
| | Behandlungsdauer | 10 Sekunden |
| Für Epoxidharzpapier: | | |
| | Oleumkonzentration | 35% SO$_3$ |
| | Behandlungsdauer | 20 Sekunden |

Nach der Kupferabscheidung (Schichtdicke 5 µm) wurde die Durchkontaktierung kontrolliert. Das Ergebnis war einwandfrei.

### Beispiel 4

Eine gebohrte kupferkaschierte Epoxidharzplatte wurde analog dem Beispiel 1 behandelt. Im Schritt 9, Ätzen, wurde eine handelsübliche Ätzlösung auf Basis von Wasserstoffperoxid bei 50°C, 2 Minuten lang angewendet. Die Durchkontaktierung und der Leiterbildaufbau waren einwandfrei.

### Beispiel 5

Kupferkaschierte glasfaserverstärkte Epoxidharzplatten wurden analog dem Beispiel 1 behandelt. Im Behandlungsschritt 11 (Aktivieren) wurden verschiedene Aktivierungslösungen angewendet. Die Behandlung in den Aktivierungslösungen dauerte jeweils 3 Minuten und erfolgte bei Raumtemperatur. Zusammensetzungen der Lösung:

Aktivierungslösung Nr. 1

| | |
|---|---|
| Palladium (als Palladiumnitrat) | 200 mg/l |
| Schwefelsäure, konzentriert | 20 g/l |
| Pyridin | 32 g/l |
| pH-Wert | 2,7 |

Aktivierunglösung Nr. 2

| | |
|---|---|
| Palladium (als Palladiumnitrat) | 200 mg/l |
| Schwefelsäure, konzentriert | 20 g/l |
| Ethanolamin | 24 g/l |
| pH-Wert (mit Ethanolamin eingestellt) | 2,1 |

Aktivierungslösung Nr. 3

| | |
|---|---|
| Palladium (als Palladiumnitrat) | 200 mg/l |
| Schwefelsäure, konzentriert | 20 g/l |
| Butylamin | 30 g/l |
| pH-Wert (mit Butylamin eingestellt) | 2,0 |

Aktivierungslösung Nr. 4

| | |
|---|---|
| Palladium (als Palladiumchlorid) | 200 mg/l |
| Schwefelsäure, konzentriert | 10 g/l |
| Ammoniumchlorid | 2,4 g/l |
| pH-Wert (mit Ammoniak eingestellt) | 2,6 |

Aktivierungslösung Nr. 5

| | |
|---|---|
| Palladium (als Palladiumnitrat) | 200 mg/l |
| Salpetersäure, konzentriert | 40 g/l |
| pH-Wert (mit Ammoniak eingestellt) | 2,7 |

Bei der Behandlung in den angeführten Palladiumlösungen wurde keine merkbare Zementierung von Palladium auf der Kupferkaschierung beobachtet. Die Durchkontaktierung und der Zustand der Negativmaske wurden nach Abscheidung von 5 µm Kupfer geprüft. Die Durchkontaktierung war einwandfrei, die Negativmaske bleib unbedeckt, die Konturen der Leiterbahnen waren einwandfrei.

Beispiel 6

Analog dem Beispiel 1 wurde eine kupferkaschierte gebohrte Epoxidharzplatte behandelt. Bei dem Behandlungsschritt Nr. 11 wurde eine Aktivierung auf Basis von Palladium und Ethylamin verwendet. Die Palladiumkonzentration betrug 200 mg/l. Die Schwefelsäuremenge entsprach annähernd stöchiometrisch der zugesetzten Menge an Ethylamin. Bei Ethylaminkonzentration von 17,9 g/l (pH der Lösung war 2,0) wurde auf der Kupferkaschierung eine mit blossem Auge merkbare Palladiumzementierung festgestellt. Trotzdem war die Durchkontaktierung und die Haftfestigkeit der galvanisch abgeschiedenen Kupferschicht einwandfrei. Eine Erhöhung des pH-Wertes der Aktivierung auf 3,1 brachte eine deutliche Verringerung der Palladiumzementierung auf der Kupferkaschierung. Die Durchkontaktierung war einwandfrei. Anschliessend wurde zu dieser Lösung Schwefelsäure zugesetzt und der pH-Wert mit Ethylamin auf 3,2 eingestellt. Die Konzentration an Ethylamin betrug dann 38 g/l. Auch in diesem Fall war die Durchkontaktierung einwandfrei, wobei keine Bedeckung der Negativmaske mit Metall erfolgte.

Beispiel 7

Analog dem Beispiel 6 wurden Aktivierungen auf Basis von Glycin bzw. Ethylendiamin angesetzt. Bei den am Anfang gewählten Konzentrationen des Komplexbildners und Palladiums und pH-Wert der Aktivierungslösung wurden unbefriedigende Ergebnisse erzielt. Durch Veränderungen der Konzentrationen und des pH-Wertes wurden brauchbare Arbeitsbedingungen gefunden. Die nachstehenden Tabellen zeigen, wie die Veränderungen nach und nach erfolgten und die Ergebnisse der Versuche.

Die Zusammensetzungen der Lösungen waren:

| | |
|---|---|
| Palladium (als Palladiumnitrat) | Konzentration s. Tabelle |
| Schwefelsäure, konzentriert | 10 g/l |
| Komplexbildner | s. Tabelle |
| pH-Wert (gegebenenfalls mit NaOH eingestellt) | s. Tabelle |

| Palladium Konzentration (mg/l) | Glycin- Konzentration (g/l) | pH-Wert | Durchkontaktierung | Palladiumzementierung | Zustand der Negativmaske |
|---|---|---|---|---|---|
| 200 | 2,5 | 1,0 | unvollständig | keine merkbare | nicht bestimmt |
| 200 | 20,0 | 1,9 | keine | keine merkbare | nicht bestimmt |
| 200 | 0,25 | 2,1 | unvollständig | keine merkbare | nicht bestimmt |
| 300 | 0,20 | 3,0 | einwandfrei | sichtbar | nicht bestimmt |
| 200 | 0,15 | 2,9 | einwandfrei | keine merkbare | einwandfrei |
| 100 | 0,075 | 2,0 | einwandfrei | keine merkbare | einwandfrei |
| 100 | 0,075 | 3,0 | einwandfrei | keine merkbare | einwandfrei |

| Palladium- Konzentration (mg/l) | Ethylendiamin- Konzentration (g/l) | pH-Wert | Durchkontaktierung | Palladiumzementierung | Zustand der Negativmaske |
|---|---|---|---|---|---|
| 200 | 6,2 | 1,2 | keine | keine merkbare | nicht bestimmt |
| 200 | 1,2 | 1,0 | unvollständig | sichtbar | nicht bestimmt |
| 200 | 1,2 | 2,0 | unvollständig | keine merkbare | nicht bestimmt |
| 200 | 0,12 | 2,0 | einwandfrei | keine merkbare | einwandfrei |
| 200 | 0,24 | 2,0 | einwandfrei | keine merkbare | einwandfrei |
| 200 | 0,60 | 2,0 | unvollständig | keine merkbare | einwandfrei |

EP 0 160 966 B1

Beispiel 8

Analog dem Beispiel 1 wurden gebohrte, kupferkaschierte Platten aus Epoxidharzlaminat behandelt, die Zusammensetzung der chemischen Nickelbäder, sowie die Bedingungen bei der chemischen Vernickelung (Behandlungsschrit Nr. 15) wurden variiert.

Chemisches Nickelbad Nr. 1

Wie im Beispiel 1 angeführt.

Chemisches Nickelbad Nr. 2

| | |
|---|---|
| Nickel (als Nickelsulfat) | 6 g/l |
| Äpfelsäure | 30 g/l |
| Bernsteinsäure | 10 g/l |
| Dimethylaminoboran | 2 g/l |
| Blei (als Acetat) | 0,3 mg/l |
| pH (eingestellt mit Natriumhydroxid) | 5,5 |
| Temperatur | 50°C |
| Behandlungsdauer | 15 Min. |

Chemisches Nickelbad Nr. 3

Analog dem chemischen Nickelbad Nr. 2; anstelle von Blei wurde Thioharnstoff (0,2 mg/l) verwendet.

Bei Anwendung von allen drei chemischen Nickelbädern wurde einwandfreie Durchkontaktierung festgestellt.

Beispiel 9

Dieses Beispiel zeigt die Anwendung von lösungsmittellöslichem Resist und einem chemischen Kupferbad.

Analog dem Beispiel 1 wurde in dem Verfahrensschritt Nr. 5 die Negativmaske mittels eines lösungsmittellöslichen Fotoresist hergestellt. Die chemische Metallisierung (Verfahrensschritt 15) erfolgte in einem handelsüblichen chemischen Kupferbad. Die Durchkontaktierung und der Zustand der Negativmaske wurden nach der galvanischen Verkupferung geprüft und als einwandfrei befunden.

Beispiel 10

Nach dem Verfahrensablauf wie im Beispiel 1 angeführt wurden 20 Platten für einen Löttest hergestellt. Die Bedingungen bei der Behandlung im gasförmigen Schwefeltrioxid wurden entsprechend dem Beispiel 2 variiert. Nach dem Verfahrensschritt 24 erfolgte eine Aufschmelzung der Leiterplatten. Alle Leiterplatten passierten den Löttest ohne Fehler.

Beispiel 11 (Vergleichsbeispiel)

Eine gebohrte kupferkaschierte Platte aus Epoxidharzlaminat wurde mit Fotoresist beschichtet. Nach der Herstellung der Negativmaske wurde das übliche Durchkontaktieren durchgeführt. die einzelnen Behandlungsschritte waren:

1. Reinigen der Platten in einem handelsüblichen sauren Reiniger;
2. Spülen in Wassser;
3. Ätzen der Platte in Natriumpersulfatlösung;
4. Spülen in Wasser
5. Aktivieren in einem Aktivierungssystem auf Basis
5. Palladium-Kolloid, wobei die einzelnen Verfahrensschritte der Aktivierung waren:
a) Vortauchen;
b) Behandlung im Palladium-Kolloid;
c) Spülen;
d) Beschleunigen;
e) Spülen.
6. Chemische Metallisierung in einem chemischen Nickelbad.

Das chemische Nickelbad hatte die gleiche Zusammensetzung wie in Beispiel 1 angeführt. Die Durchkontaktierung war einwandfrei. Die Negativmaske war ca. zur Hälfte mit Metall bedeckt. Dadurch ist die Platte unbrauchbar geworden.

### Beispiel 12 (Vergleichsbeispiel)

Eine gebohrte kupferkaschierte Platte aus Epoxidharzlaminat wurde in einer wässrigen Dimethylformamidlösung (1:1) 5 Minuten lang bei Raumtemperatur behandelt und in Wasser gespült. Es folgte eine Behandlung in einem Chromsäure/Schwefelsäure-Wasser-Gemisch folgender Zusammensetzung:

| | |
|---|---|
| Chromsäure | 10 Gew.-% |
| Schwefelsäure | 50 Gew.-% |
| Wasser | 40 Gew.-% |

Die Behandlung dauerte 5 Minuten bei Raumtemperatur. Entsprechend dem Beispiel 1 wurde die Platte aktiviert und chemisch vernickelt, d.h. im einzelnen wurde die Platte entsprechend den Verfahrensschritten 6—16, wie im Beispiel 1 angeführt, behandelt.

Nach einer galvanischen Verkupferung zeigte sich eindeutig, dass die Bohrungen unbedeckt blieben, die Platte war nicht durchkontaktiert.

### Beispiel 13 (Vergleichsbeispiel)

Dieses Beispiel bezieht sich auf eine Umstellung des Verfahrensablaufes. Ein gebohrte kupferkaschierte Platte wurde wie nachfolgend beschrieben behandelt:

1. Behandlung in einer $SO_3$-haltigen Atmosphäre wie im Beispiel 1;
2. Spülen in Wasser.
3. Aktivieren analog dem Schritt 11 bis 14 des Beispiels 1;
4. Trocknen der Platte, Unterbrechen der Behandlungsfolge.

Auf die Herstellung der Negativmaske, die sonst an dieser Stelle erfolgen würde, wurde verzichtet.

5. Fortsetzung der Behandlung: Reinigen, Anätzen, Behandlung im chemischen Nickelbad und galvanischem Kupferbad — analog dem Beispiel 1, Schritte 7 bis 10 und 15 bis 18.

Ergebnis: keine vollständige Durchkontaktierung wurde festgestellt.

### Beispiel 14 (Vergleichsbeispiel)

Analog dem Beispiel 5 wurde ein Aktivierungslösung (200 mg/l Palladium) mit 2-Aminopyridin (0,95 g/l) geprüft. Der pH-Wert wurde variiert, die Behandlung im gasförmigen Schwefeltrioxid bei einigen Proben weggelassen. Die Ergebnisse zeigt die nachfolgende Tabelle.

| $SO_3$-Behandlung ja: + nein: − | pH-Wert der Aktivierung | Durchkontaktierung | Palladiumzementierung | Bedeckung der Negativmaske |
|---|---|---|---|---|
| + | 1,0 | einwandfrei | keine | keine |
| + | 3,0 | einwandfrei | keine | keine |
| + | 5,0 | einwandfrei | keine | bedeckt |
| + | 7,1 | einwandfrei | keine | bedeckt |
| + | 9,1 | einwandfrei | keine | bedeckt |
| − | 1,0 | fehlerhaft | keine | keine |
| − | 3,0 | fehlerhaft | keine | keine |
| − | 5,0 | fehlerhaft | keine | bedeckt |
| − | 7,1 | einwandfrei | keine | bedeckt |
| − | 9,1 | einwandfrei | keine | bedeckt |

## Patentansprüche

1. Verfahren zur Herstellung von Metallmustern auf isolierenden Trägern, insbesondere von gedruckten Schaltungen, bei denen diese Träger zwecks elektrischer Verbindung mit Metallfolien beschichtet und mit Löchern versehen sind und die Metallmuster auf der Oberfläche des Trägers mit Hilfe einer Negativmaske nach dem Subtraktivverfahren hergestellt werden, wobei das Verfahren den folgenden Verfahrensablauf aufweist:

Behandlung in gasförmigem Schwefeltrioxid,

Aufbringen einer dem herzustellenden Metallmuster entsprechenden Negativmaske,

Durchkontaktierung und anschließender Aufbau des metallmusters, realisiert durch die folgenden Verfahrensschritte: Aktivierung mittels einer ionogenen Edelmetallösung, Behandlung in einer Reduktionsmittellösung, chemische oder chemische und elektrolytische Abscheidung, wobei die Metallabscheidung nur auf der Oberfläche der herzustellenden Metallmuster stattfindet,

Entfernen der Negativmaske und

Ätzen der freibleibenden Metallfolie.

2. Verfahren nach Anspruch 1, dadurch gekennzeichnet, dass bei der Behandlung Schwefeltrioxid in Konzentrationen von 10 mg/l bis zu Konzentrationen, die dem Dampfdruck von Schwefeltrioxid über 65%igem Oleum bei 25°C entsprechen, angewendet wird.

3. Verfahren nach Anspruch 1 und 2, dadurch gekennzeichnet, dass die Behandlung in gasförmigem Schwefeltrioxid 1 Sekunde bis 20 Minuten, vorzugsweise 5 Sekunden bis 5 Minuten, dauert.

4. Verfahren nach Anspruch 1, dadurch gekennzeichnet, dass die Negativmaske mit Hilfe von Fotoresist oder Siebdruck hergestellt wird.

5. Verfahren nach Anspruch 1, dadurch gekennzeichnet, dass die Aktivierungslösung Palladiumsalze enthält.

6. Verfahren nach Anspruch 1, dadurch gekennzeichnet, dass zu der Aktivierungslösung eine oder mehrere Verbindungen zugesetzt werden, die basischen Stickstoff enthalten.

7. Verfahren nach Anspruch 1 und 6, dadurch gekennzeichnet, dass das Verhältnis der molaren Konzentration der stickstoffhaltigen Verbindung, bezogen auf Stickstoff, zur molaren Konzentration des Palladiumsalzes mindestens 2 beträgt.

8. Verfahren nach Anspruch 1 und 6, dadurch gekennzeichnet, dass die Aktivierungslösung Ammoniumionen enthält.

9. Verfahren nach Anspruch 1 und 6, dadurch gekennzeichnet, dass die Aktivierungslösung primäre, sekundäre oder tertiäre Amine enthält.

10. Verfahren nach Anspruch 1, 5 und 6, dadurch gekennzeichnet, dass der pH-Wert der Aktivierungslösung zwischen 1 bis 7, vorzugsweise 2 bis 3, eingestellt wird.

11. Verfahren nach Anspruch 1, dadurch gekennzeichnet, dass die Reduktionsmittellösung Aminoborane enthält.

12. Verfahren nach Anspruch 1 und 11, dadurch gekennzeichnet, dass die Reduktionsmittellösung Dimethylaminoboran enthält.

13. Verfahren nach Anspruch 1, dadurch gekennzeichnet, dass als Negativmaske lösungsmittellösliche oder alkalilösliche Fotoresiste oder Siebdruckfarben verwendet werden.

14. Verfahren nach Anspruch 1, dadurch gekennzeichnet, dass als chemisches Metallisierungsbad ein chemisches Nickelbad verwendet wird.

15. Verfahren nach Anspruch 1 und 11, dadurch gekennzeichnet, dass das chemische Nickelbad Aminoborane als Reduktionsmittel enthält.

16. Verfahren nach Anspruch 1 und 12, dadurch gekennzeichnet, dass das chemische Nickelbad Dimethylaminoboran enthält.

17. Verfahren nach Anspruch 1 und 11, dadurch gekennzeichnet, dass der pH-Wert des chemischen Nickelbades zwischen 5 und 7 eingestellt wird.

## Revendications

1. Procédé pour la réalisation de dessins métalliques sur des supports isolants, en particulier de circuits imprimés, dans lesquels ces supports, pour assurer la connexion électrique, sont revêtus de feuilles métalliques et pourvus de trous, et les dessins métalliques sont réalisés sur la surface du support à l'aide d'un masque négatif par le procédé soustractif, le procédé présentant les étapes suivantes:

traitement dans du trioxyde de soufre gazeux,

application d'un masque négatif correspondant au dessin métallique à réaliser,

métallisation des trous, puis constitution du dessin métallique, réalisée par les étapes suivantes: activation à l'aide d'une solution ionique d'un métal précieux, traitement dans une solution d'un réducteur, dépôt chimique ou chimique et électrolytique, le dépôt du métal n'ayant lieu que sur la surface du dessin métallique à réaliser,

enlèvement du masque négatif, et

gravure de la feuille métallique restante.

2. Procédé selon la revendication 1, caractérisé en ce que, lors du traitement, on utilise du trioxyde de soufre à des concentrations allant de 10 mg/litre aux concentrations correspondant à la pression de vapeur du trioxyde de soufre au-dessus de l'oléum à 65% à 25°C.

3. Procédé selon la revendication 1 ou 2, caractérisé en ce que le traitement dans le trioxyde de soufre gazeux dure de 1 seconde à 20 minutes, de préférence de 5 secondes à 5 minutes.

4. Procédé selon la revendication 1, caractérisé en ce que le masque négatif est réalisé à l'aide d'une photoréserve ou par sérigraphie.

5. Procédé selon la revendication 1, caractérisé en ce que la solution d'activation contient des sels de palladium.

6. Procédé selon la revendication 1, caractérisé en ce qu'on ajoute à la solution d'activation un ou plusieurs composés contenant de l'azote basique.

7. Procédé selon les revendications 1 et 6, caractérisé en ce que le rapport de la concentration molaire du composé azoté, calculée en azote, à la concentration molaire du sel de palladium est d'au moins 2.

8. Procédé selon les revendications 1 et 6, caractérisé en ce que la solution d'activation contient des ions ammonium.

9. Procédé selon les revendications 1 et 6, caractérisé en ce que la solution d'activation contient des amines primaires, secondaires ou tertiaires.

10. Procédé selon les revendications 1, 5 et 6, caractérisé en ce que le pH de la solution d'activation est de 1 à 7, de préférence de 2 à 3.

11. Procédé selon la revendication 1, caractérisé en ce que la solution de réducteur contient des aminoboranes.

12. Procédé selon les revendications 1 et 11, caractérisé en ce que la solution de réducteur contient du diméthylaminoborane.

13. Procédé selon la revendication 1, caractérisé en ce qu'on utilise comme masque négatif des photoréserves ou des encres pour sérigraphie, solubles dans les solvants ou dans les alcalis.

14. Procédé selon la revendication 1, caractérisé en ce qu'on utilise comme bain de métallisation chimique un bain de nickelage chimique.

15. Procédé selon les revendications 1 et 11, caractérisé en ce que le bain de nickelage chimique contient des aminoboranes en tant que réducteurs.

16. Procédé selon les revendications 1 et 12, caractérisé en ce que le bain de nickelage chimique contient du diméthylaminoborane.

17. Procédé selon les revendications 1 et 11, caractérisé en ce que le pH du bain de nickelage chimique est ajusté à une valeur comprise entre 5 et 7.

## Claims

1. Process for the production of metal patterns on insulating substrates, especially of printed circuits, in which these substrates are coated with metal foil and are provided with holes for electrical connection and the metal patterns are produced on the surface of the substrate with the aid of a negative mask according to the subtractive process, wherein the process comprises the following sequence:

treatment in gaseous sulfur trioxide,

application of a negative mask corresponding to the metal pattern to be produced,

plating-through and subsequent formation of the metal pattern, realized by the following process steps: activation by means of an ionogenic noble metal solution, treatment in a reduction agent solution, chemical or chemical and electrolytic deposition, wherein the metal deposition takes place only on the surface of the metal pattern to be produced,

removal of the negative mask, and etching of the exposed metal foil.

2. Process according to claim 1, characterized in that during the treatment sulfur trioxide is used in concentrations of 10 mg/l up to concentrations which correspond to the vapour pressure of sulfur trioxide above 65% oleum at 25°C.

3. Process according to claim 1 and 2 characterized in that the treatment in gaseous sulfur trioxide lasts 1 second to 20 minutes, preferably 5 seconds to 5 minutes.

4. Process according to claim 1, characterized in that the negative mask is produced with the aid of photoresist or screen printing.

5. Process according to claim 1 characterized in that the activating solution contains palladium salts.

6. Process according to claim 1, characterized in that one or more compounds which contain basic nitrogen are added to said activating solution.

7. Process according to claim 1 and 6, characterized in that the ratio of the molar concentration of the nitrogenous compound, to the molar concentration of the palladium salt is at least 2 based on nitrogen.

8. Process according to claim 1 and 6, characterized in that the activating solution contains ammonium ions.

9. Process according to claim 1 and 6, characterized in that the activating solution contains primary, secondary or tertiary amines.

10. Process according to claim 1, 5 and 6, characterized in that the pH value of the activating solution is set between 1 and 7, preferably 2 to 3.

11. Process according to claim 1, characterized in that the reducing agent solution contains aminoboranes.

12. Process according to claim 1 and 11, characterized in that the reducing agent solution contains dimethylaminoborane.

13. Process according to claim 1, characterized in that solvent soluble or alkali soluble photoresists or screen printing inks are used as the negative mask.

14. Process according to claim 1, characterized in that a chemical nickel bath is used as the chemical metallization bath.

15. Process according to claim 1 and 11, characterized in that the chemical nickel bath contains aminoboranes as reducing agent.

16. Process according to claim 1 and 12, characterized in that the chemical nickel bath contains dimethylaminoborane.

17. Process according to claim 1 and 11, characterized in that the pH value of the chemical nickel bath is set between 5 and 7.